# EUROPEAN PATENT APPLICATION

(11) **EP 4 478 744 A1**
(43) Date of publication of application: **18.12.2024**
(21) Application number: 24181665.1
(22) Date of filing: 12.06.2024
(51) Int. Cl.: H04R 25/00, H01M 50/202, H01M 50/298

(54) **FLEXIBLE CONNECTING DEVICE FOR A RECHARGEABLE BATTERY OF A HEARING AID**

(30) Priority: 16.06.2023 EP 23179750; 06.02.2024 EP 24155986
(71) Applicant: Oticon A/S, 2765 Smørum (DK)
(72) Inventor: YTTERDAL, Helge Åsmund, DK-2765 Smørum (DK); JOHANSEN, Jesper B., DK-2765 Smørum (DK); SIGURDSSON, Atli Gilbert, DK-2765 Smørum (DK); DE MASI, Alessandro, DK-2765 Smørum (DK); NIROUMAND, Farideh Javidi, DK-2450 Copenhagen SV (DK)
(74) Representative: Demant

(57) **Abstract**

The present disclosure relates to a connecting device (1), wherein the connecting device (1) is configured to cooperate with a battery unit (2) of a hearing aid and with an electronic component (3) of the hearing aid. The connecting device (1) defines a connecting state, where the connecting device (1) essentially holds the battery unit (2) in position with respect to the electronic component (3). The connecting device is configured to provide a connection to the battery unit (2) via at least one welding unit (WU1, WU2) and the connecting device (1) is further configured to provide a connection to the electronic component (3) of the hearing aid via at least one soldering unit (SU1).

The present disclosure further relates to a hearing aid that comprises a connecting device (1), which cooperates with a rechargeable battery (2.1) of a battery unit (2) and with an electronic component (3), preferably an amplifier (3).

## Description

### FIELD

The present disclosure relates to a connecting device, wherein the connecting device is configured to cooperate with a battery unit of a hearing aid and with an electronic component of the hearing aid. The connecting device defines a connecting state, where the connecting device essentially establishes part of a connection to the electronic component. The disclosure further relates to a hearing aid that comprises such connecting device.

### BACKGROUND

Devices or parts providing a connecting between a battery unit and an electronic component, e.g. an amplifier, of a hearing aid so that the battery unit, comprising a rechargeable battery, have been implemented using metallic arms which also help holding the battery unit in position. The electronic component is placed or positioned on a substrate, such as a rigid printed circuit board.

While these kind of connecting unit applications have proven to provide a reliable attachment function, they have the disadvantage of causing a kind of hard-coupling from the battery mass to the electronic components connect to. Such hard-coupling effect, especially in the case of severe motion of the entire hearing aid or in the case of external mechanical impact on the hearing aid, beyond a certain level of severity, can lead to damages of the connecting device itself as well as to a damage of the respective components to be connected by the connecting device.

Therefore, there is a need to provide a solution that addresses at least some of the above-mentioned challenges that come along with the known connecting devices in hearing aids. Further, at least the present disclosure provides an alternative to known structures and battery connections in hearing aids.

### SUMMARY

Thus, it is the object of the present disclosure to provide a connecting device for a hearing aid, which do not show the disadvantages described above, or at least show them to a lesser extent, and which, in particular, ensures a reliable, yet flexible, attachment function and whose design provides a reduced risk for damage of the connected components and of the connecting device itself.

The above objects are achieved starting from a connecting device according to the preamble of claim 1 by the features of the characterizing part of claim 1. The above objects are further achieved by the hearing aid according to claim 15.

The present disclosure is based on the technical teaching that a reliable, yet flexible, attachment function of the connecting device with a design that provides a reduced risk for damage of the connected components and of the connecting device itself can be realized, if the connecting device is designed such that a detachable connection to the battery unit via at least one welding unit, in particular one detachable connection to a rechargeable battery via a first welding unit and one detachable connection to a housing unit for the battery via a second welding unit, and a detachable connection to the electronic component of the hearing aid via at least one soldering unit is provided. By the appropriate welding processes (electrode positive and electrode-negative welding) and soldering processes applied, a simple, yet reliable, physical/mechanical and electrical connection can be provided.

In other words, the present disclosure has recognized that a connecting device with the chosen solution of providing connecting units to the other components in the form of welding units and soldering units as described above, offers a predictability feature of the connection design but at the same time offers a flexibility feature in the connection design. In the context of the present disclosure, detachable means that it is possible to detach the two detachably connected components without destroying then, however, it is the intention that the welding(s) is able to continuously and reliably connect the two parts.

A battery unit may be provided with a connecting device being welded thereto. The welding may be harder to undo but may provide a more reliable connection between the battery and the connecting device. During production/assembly of the hearing aid, the battery unit with the connecting device may be soldered to a circuit board, such as prior to assembly within a hearing aid shell and/or rack or frame which is then subsequently placed in a hearing aid shell. The battery unit may be a battery or a battery and a housing for the battery. Such housing may comprise additional components, such as a coil configured to pick up a wireless charge signal. The connecting unit may be attached to such a housing or directly to a battery of the battery unit.

In the present context, the term detachable means that the soldered connection may be undone, such as by desoldering the connection, which may be achieved by means of heating. It is envisioned that the detachable connection is permanent for the duration of the use of the hearing aid which comprise this connecting device, but in case of a need for replacement of the battery unit, such as failure or fault in the secondary battery the battery unit may be replaced without damaging the connecting device. This could then include desoldering the connection at a soldering unit, replacing the battery unit with a new battery unit and reapplying the solder so that a new, detachable, connection is established.

Moreover, as regards the design of the connecting device itself, the disclosure has recognized that by a certain compliance provided by the chosen structure and material characteristic of the connecting device itself, in particular by an appropriate shaped design of a flexible printed circuit boards, or generally by a flexible substrate having at least one conducting path, which in a connecting state of the connecting device can act in a manner of a spring element allowing a controlled displacement in the connecting state between predetermined displacement limits, together with providing the connecting units in the form of welding and soldering units as described above, a sufficient compliance of the connecting device in its connecting state is achieved, thereby reducing the risk for component damages caused by hard-coupling scenarios. The printed circuit board could be either of a only/fully flexible type, a semi-rigid type or a combination thereof, such as if different types are connected. For the uses where the printed circuit bord is to be twisted and/or moved, a flexible printed circuit board type is currently preferred. The connecting device may comprise a flexible substrate. This is contemplated to allow the connecting device to be easily installed in the interior of a hearing aid after having been fixed to the battery unit and/or circuit board.

Hence, according to one aspect, the present disclosure provides a connecting device, wherein the connecting device is configured to cooperate with a battery unit of a hearing aid and with an electronic component of the hearing aid. In the present context, the battery unit may simple be a battery. The connecting device defines a connecting state, where the connecting device may help hold the battery unit in position with respect to the electronic component. The electronic component may be placed on a substrate, such as a printed circuit board, to which the connecting device is connected.

The connecting device may be configured to provide a temporarily fixed connection which may be detachable from the battery unit via at least one welding unit and the connecting device may be further configured to provide a temporarily fixed connection which may be detachable from the electronic component of the hearing aid via at least one soldering unit. The electronic component may for example be an amplifier of the hearing aid. By these detachable connections provided in the form of the at least one welding unit and at least one soldering unit, the above described effects can be fully achieved. The electronic component is placed or positioned on a substrate, such as a rigid printed circuit board. The connecting device may be connected to the substrate so as to establish the electrical connection between the battery unit and the electronic component.

Further on, all of the above-described configurations using welding and soldering units have the advantage that with further variants, the detachable connection to the battery unit via the at least one welding unit may be provided as physical and electrical detachable connection, and that the detachable connection to the electronic component of the hearing aid via the at least one soldering unit may be provided as physical and electrical detachable connection.

In further variants, the connecting device may be configured to provide the detachable connection to a rechargeable battery and a battery housing of the battery unit via at least a first and a second welding unit and to provide a detachable connection to the electronic component in the form of an amplifier via the at least first soldering unit.

Further electrical paths are used to establish signal path connections from the soldering units to the relevant component(s).

Basically, the connecting device can have an arbitrary number of welding units and soldering units. However, already one welding unit and already one soldering unit may be sufficient to achieve the above-described reliable detachable connections.

In further variants of the disclosure, the at least one welding unit may comprise at least a first welding unit and a second welding unit and the at least one soldering unit may comprise at least a first soldering unit. Advantageously, the first and second welding units may be formed by laser welding process and the first soldering unit is formed by soldering process.

In addition or as an alternative, the first welding unit may be formed by electrode-negative welding, the second welding unit may be formed by electrode-positive welding, and/or the first soldering unit may be formed by soldering. By such connecting unit configurations, a manageable magnetic field may be generated for the system without a hard-coupling from the mass of the battery and the housing unit to the electronic component.

In further variants, the connecting device may be configured to provide, in the connecting state, the detachable connection to the battery unit via at least a first welding unit and a second welding unit. Preferably, in such a variant, the first welding unit acts between a first connecting area of a first section of the connecting device and an essentially free surface of a battery of the battery unit, where the battery rests within a housing unit of the battery unit. Preferably, the housing unit may be made of stainless steel. Also here, by such connecting unit configurations, a manageable magnetic field can be generated for the system without a hard-coupling from the mass of the battery and the housing unit to the electronic component.

Any of the above-described variants providing at least a first and second welding unit and at least a first soldering unit, may, in a further variant of the disclosure, provide a further beneficial configuration in terms of simple, yet reliable, detachable physical and electrical connections, when the first welding unit comprises at least two first welding unit zones. In such a case, advantageously, the at least two first welding unit zones may be located adjacent to each other. In addition or as alternative, the second welding unit may comprise at least two second welding unit zones, where, again, the at least two second welding unit zones may be located adjacent to each other. In addition or as an alternative, the first soldering unit may comprise at least two first soldering unit zones, where the at least two first soldering unit zones may be located adjacent to each other. All of these variants provide the advantage that a manageable magnetic field can be generated for the system without a hard-coupling from the mass of the battery and the housing unit to the electronic component.

In further variants, in particular in combination with the previously described variant, the connecting device may be configured to provide, in the connecting state, the detachable connection to the electronic component via at least a first soldering unit. Advantageously, then the first soldering unit acts between a third connecting area of a third section of the connecting device and the electronic component of the hearing aid. Advantageously, the electronic component is an amplifier of the hearing aid. In addition, or as an alternative, the first soldering unit may comprise at least two first soldering unit zones, where the at least two first soldering unit zones may be located adjacent to each other.

Basically, the shape of the connecting device can be of any configuration as long as the reliability of the detachable connection according to the disclosure is ensured. Very beneficial configurations in terms of simple, yet reliable, configuration may be achieved if the connecting device, at least when considered in a non-connecting state when the connecting device is essentially unloaded, in its axis of minor extension, is essentially foil shaped, and in a, in particular essentially curved, area of main extension is essentially U-shaped or V-shaped.

In further variants providing a simple, yet reliable, connecting device, the connecting device may comprise at least a first and second arm-like element and a transition element, wherein the first and second arm-like elements are connected to each other via the transition element. The above-described variant of the connecting device with two arm-like elements and a transition element, may, in a further variant, provide the additional advantageous technical features that the transition element may comprise a first section of the connecting device with a first connecting area for a first welding unit. Then, the first welding unit may be configured to act between the first connecting area and a battery of the battery unit, where the battery rests within a housing unit of the battery unit.

Further, the second arm-like element may comprise a third section of the connecting device with a third connecting area for first soldering unit. Then, the first soldering unit may be configured to act between the third connecting area and the electronic component of the hearing aid, where the electronic component advantageously is an amplifier of the hearing aid. All of these variants provide the advantage that a manageable magnetic field can be generated for the system without a hard-coupling from the mass of the battery and the housing unit to the electronic component.

In further variants, the connecting device may comprise at least a first and second arm-like element and a transition element, wherein the first and second arm-like elements are then connected to each other via the transition element, the second arm-like element may provide a stiffness characteristic, which may vary section-wise, and may provide a geometric curvature in a non-connecting state when the connecting device is essentially unloaded such that in the connecting state, the second-arm like element at least temporarily cooperates with and is detachably fixable to the electronic component of the hearing aid. Then, advantageously, at least a section of the second arm-like element in the connecting state acts in a manner of a spring element allowing a controlled displacement of the second-arm like element in the connecting state between predetermined displacement limits. Hence, a certain compliance by the connecting device design is also provided and counteracts hard-coupling effects from the mass of the battery and the housing unit to the electronic component.

In further variants, at least a section of the connecting device may be formed by at least one printed circuit board. In addition, or as an alternative, the connecting device may be essentially form from at least one flexible printed circuit board, such as two or more connected flexible printed circuit boards. In any of these variants, the connecting device, in its axis of minor extension, may, at least when considered in a non-connecting state when the connecting device is essentially unloaded, be essentially foil shaped, and in a, in particular, essentially curved, area of main extension may be essentially U-shaped or V-shaped. In addition, or as alternative, the connecting device may comprise at least a first and second arm-like element and a transition element, wherein the first and second arm-like elements are connected to each other via the transition element.

In an aspect, the present disclosure provides a hearing aid having a battery, such as a rechargeable battery, a substrate carrying an electronic component, such as an active electronic component, such as a signal processor, also known as an amplifier. The hearing aid may further comprise a connection device or unit configured to establish an electrical connection from the battery to the electronic component. The connection device or unit may have a flexible body and may be made from a flexible printed circuit board. The connection device or unit may be soldered to the battery at one end, and to the substrate at another end of the connection device or unit. The connection device or unit may be connected to both a positive pole and a negative pole of the battery, such as via two solder pads on respective positive and negative poles of the battery. At the substrate, the connecting device or unit may be connected via solder pads or via a plug-and-socket connector, where the solder pads provide a fixated, and thus mechanical stable, connection, the plug-and-socket connection may provide a quick-to-release connection. The latter providing a more simple manufacturing process of the hearing aid.

A hearing aid as described herein may include a shield part or component arranged in a housing of the hearing aid, such as in a behind-the-ear housing. The shield part or shield component may form part of, or be, the connecting device as described above. The shield component may be arranged so as to at least partly shield a battery in the housing of the hearing aid during wireless charging of the battery. In further variants, the shield component may be formed by at least one flexible printed circuit board and/or the shield component may be essentially made of at least one flexible printed circuit board. The at least one flexible printed circuit board may include a copper layer, additionally such a copper layer may have a thickness between Sum to 100um. The shield component may be made entirely from a metallic material, such as copper. This configuration is particularly beneficial in terms of providing a shielding function against, for example, overheating of the battery due to the generated magnetic field during wireless charging of the hearing device/aid.

The present disclosure further relates to a hearing aid with a battery unit, where the battery unit comprises a rechargeable battery that is at least temporarily housed within a housing unit of the batter unit. The hearing aid further comprises a connecting device cooperating with the battery unit and an electronic component, advantageously an amplifier, of the hearing aid, where the connecting device may be configured according to any of the above described variants or any combination thereof of the connecting device.

In further variants of the connecting device, the connecting device, when providing the detachable connection to the battery unit via the at least one welding unit, the connecting device may further be configured to cover at least a fraction, advantageously a major fraction, more advantageously at least half, of a free surface of a battery, that may be housed within a housing unit of the battery unit. In such a case, the connecting device may further provide a cover function and/or a shielding function for the battery of the battery unit, in particular against overheating of the battery when the connecting device and the detachable connected battery is exposed to a generated magnetic field.

In the present context, to cover means that when viewed directly at a major surface of the shielding device, this major surface is at least partly covering a surface part of the battery, if viewed perpendicular to this view there might not be an overlap or covering of the battery from the shielding device.

Hence, the above described connecting device, in further variants of the disclosure, may also take over further functions besides providing a reliable detachable physical connection and an electrical connection between cooperating components, in the above case between a battery unit of a hearing aid and an electronic component of the hearing aid, possibly or preferably via a further printed circuit board carrying the electronic component.

Hence, it may be desirable for example that the connecting device may further be configured as a covering device or shielding device or shielding component.

In such a case, according to another aspect of the disclosure, the connecting device may further be configured as a shielding component, where the shielding component is associated to a system comprising a hearing aid and a hearing aid charging device, wherein the hearing aid charging device may be configured for wireless charging of a hearing aid battery when the hearing aid is arranged in a charging position with respect to the hearing aid charging device, such as placed in a cavity of a hearing aid charging device. The shielding device or component may be arranged in a covering state, where the shielding component essentially rests in its position with respect to the hearing aid housing and/or the hearing aid charging device, and the shielding component may be configured to cooperate with a part of the hearing aid and/or with a part of the hearing aid charging device and with the hearing aid battery, such that, at least in the covering state, the covering device or shielding component at least partly overlaps the hearing aid battery to shield the hearing aid battery from wireless charge signals from the hearing aid charging device, that are associated to a generated magnetic field in a charging mode of the hearing aid charging device, the charging mode being a wireless charging mode. The wireless charge signals, if left unattenuated or shielded, would induce surface currents on e.g. the battery which in turn would heat the battery. The induced heat could cause harm to the battery, such as lowering of the battery lifetime and/or capacity.

In further variants of the shielding component may be configured such that, at least in the covering state, the shielding component at least partly overlaps an exposed (otherwise) free surface of the hearing aid battery during the charging mode such that the shielding component is capable of taking over essentially entirely a shielding function to provide a shielding protection for the hearing aid battery.

In further variants of the connecting device may be configured as shielding component, the shielding component may then be formed such that, at least in the covering state and in the charging mode, the shielding component overlaps a fraction of an exposed (otherwise) free surface of the hearing aid battery during the charging mode such that the shielding component is capable of taking over essentially entirely a shielding function to provide a shielding protection for the hearing aid battery, the fraction lying in the range of 30% to 90%, preferably 40% to 80%, of the exposed free surface of the hearing aid battery.

In further variants of the shielding component may comprise at least one printed circuit board, where the at least one printed circuit board comprises copper and may form a copper layer with a thickness between Sum to 100um.

In further variants, the shielding component may comprise at least one printed circuit board comprising copper, wherein the shielding component, in the covering state, is configured to cover at least a fraction of, preferably a major fraction of, more preferably more than half of, an exposed (otherwise) free surface of the hearing aid battery facing towards the shielding component during the charging mode. This includes both, or either, when the shielding component is included in a hearing aid or in a hearing aid charger device.

In further variants of the shielding component, when arranged in the covering state, and during the charging mode, at least a fraction of, preferably a major fraction of, preferably more than half of, more preferably essentially the entire, shielding component is formed as and acting as a shield to provide a shielding protection, or at least dampening, for the hearing aid battery from a charge field. In such a case, the shielding component may be configured to prevent material damage of the hearing aid battery. In addition, or as an alternative, the shielding device may be configured to cover at least a major fraction of, preferably more than half of, an exposed (otherwise) free surface of the hearing aid battery facing towards the shielding device during the charging mode. In addition, or as an alternative, the shielding device may be configured to prevent, or at least reduce the risk of, overheating of the hearing aid battery in the charging mode.

In further variants of the shielding device during the charging mode, at least a fraction of, preferably a major fraction of, preferably more than half of, more preferably essentially the entire, covering device is formed as and acting as shield to provide a shielding protection for the hearing aid battery from a charge field. In such a case, the shielding device may be formed and configured to keep at least a local surface temperature of the hearing aid battery below a limit surface temperature characteristic for the hearing aid battery. In addition, or as an alternative, the shielding device may be formed and configured to reduce a local surface temperature of the hearing aid battery compared to a reference local surface temperature where no shielding device is present for the hearing aid battery. The considerations of the maximum temperature that a battery may be allowed to be heated to may include a measurement or an estimate of an ambient temperature to the hearing aid and/or to the charger device, such as a temperature at or in a charger cavity. In such a case, the temperature of the battery may be monitored, such as via a temperature sensor in the hearing aid and/or in the charger device. If the temperature, either directly measured at the battery or estimated based on another measurement, the charging process may be stopped or slowed down, e.g. by lowering intensity of a wireless charge field, such as by including periods without applying the charge field and/or by lowering amplitude/field strength.

In further variants of the shielding device, the shielding device may be part of, such as arranged in, a charging instrument or device for a hearing aid, where the charging instrument comprises a hearing aid charging device, a hearing aid battery to be charged and the covering device according to any of the above described variants and according to any combination of the above described variants.

In further variants, the charging instrument as described above may be provided in such a way that the hearing aid charging device is a wireless charging device, wherein at least in the covering state of the shielding device, and in a wireless charging mode of the hearing aid battery, at least a fraction of the shielding or covering device, preferably essentially the entire shielding device, is formed as and acting as a shield to provide a shielding protection for the hearing aid battery. In such a case, preferably, the shielding device is configured to be applied directly, and in particular detachably, on or at an exposed (otherwise) free surface of the hearing aid battery. The shielding device may be provided at a distance from the battery so that there is no direct contact between the battery and the shielding device. This could be achieved by one or more intermediate layers of material or a gap. Preferably such intermediate layers or gaps are small so that the shielding effect is substantially maintained. Further, the shielding device may overlap a fraction of the exposed free surface of the hearing aid battery during the charging mode such that the covering device is capable of taking over essentially entirely a shielding function to provide the shielding protection for the hearing aid battery. In such a case, preferably, the fraction lies in the range of 30% to 90%, preferably 40% to 80%, of the exposed free surface of the hearing aid battery.

In further variants, as an alternative to the above described configuration, the charging instrument as described initially, at least in the covering state of the shielding device and in the charging mode, at least a fraction of the shielding device, preferably essentially the entire shielding device, is formed as and acting as a shield to provide a shielding protection for the hearing aid battery. Then, the shielding device, at least in the covering state, may be applied, in particular detachably, at an insert unit of the hearing aid charging device, wherein the insert unit may be configured to take up a hearing instrument comprising a hearing aid to be charged.

In further variants of the shielding device, the shielding device is part of a hearing instrument, where the hearing instrument comprises or is a hearing aid, a hearing aid battery and a covering device according to any of the above described covering device configurations or any combination of the above-described variants for shielding device configurations, where it is further provided that,
at least in the covering state and in the charging mode of the hearing aid battery, at least a fraction of the shielding device, preferably essentially the entire shielding device, is formed as and acting as shield to provide a shielding protection for the hearing aid battery. In such a case, the shielding device, at least in the covering state, then may be (i) either configured to be applied directly, and in particular detachably, on an outer shell of the hearing aid, or (ii) may be configured to be applied directly, and in particular detachably, on an inner shell of the hearing aid.

Further variants of the present disclosure relating to a connecting and/or shielding device will become apparent from the dependent claims and the following description of the connecting device.

A further aspect of the present disclosure relates to a hearing device comprising a connecting device. Such a hearing device may be configured so that said connecting device is configured to cooperate with a battery unit of the hearing device and with an electronic component of said hearing device. Such a connecting device could then be part of a power supply line from said battery to said electronic component.

Such a hearing device may be configured so that when said connecting device is in a connected state, where said connecting device essentially establish an electrical connection between said battery unit and said electronic component. Such a hearing device may be configured so that said connecting device is configured to provide a detachable connection to said battery unit via at least one welding unit and to provide a detachable connection to said electronic component of said hearing aid via a plug and socket connection. The plug and socket connection may be established via a connector, where one part is mounted on a substrate of an amplifier and another part is mounted on the connecting device itself. The part of the connecting device attached to the battery is preferably soldered or welded to the battery. The battery, as herein referred to as a rechargeable battery may also be called a secondary battery.

### BRIEF DESCRIPTION OF THE DRAWINGS

FIG. 1 shows a schematic illustration of a connecting device according to the disclosure that is in a connecting state where the connecting device is physically and electronically detachable connected to a battery, a housing unit and an electronic component;
FIG. 2 shows a schematic illustration of the connecting device of Figure 1, but now in a state where the connecting device is not connected to the housing unit and the electronic component;
FIG. 3 a shows a thermographic-camera image of a battery to be charged, whose free surface is entirely exposed to a magnetic field in a wireless charging mode of a battery charging device;

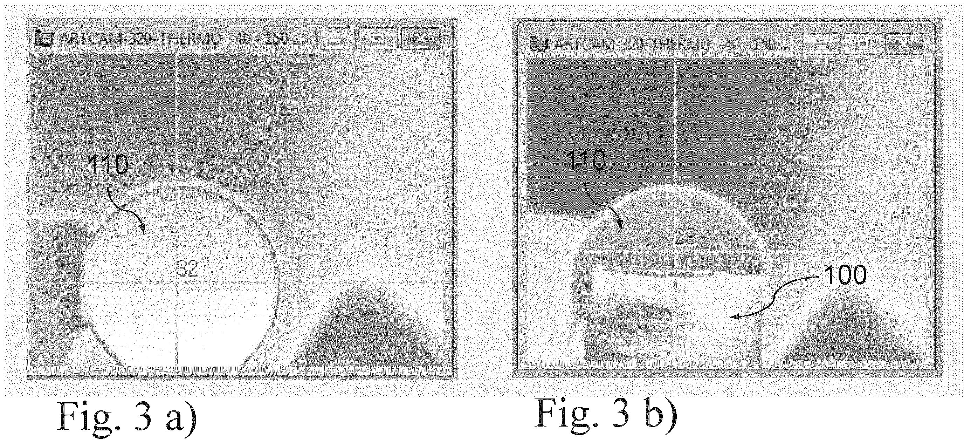

FIG. 3 b shows a thermographic-camera image of the battery of Figure 3a, but with the (otherwise) free surface only partly directly exposed to the magnetic field of the wireless charging mode of the battery charging device and partly covered by a connecting device configured as a covering device;

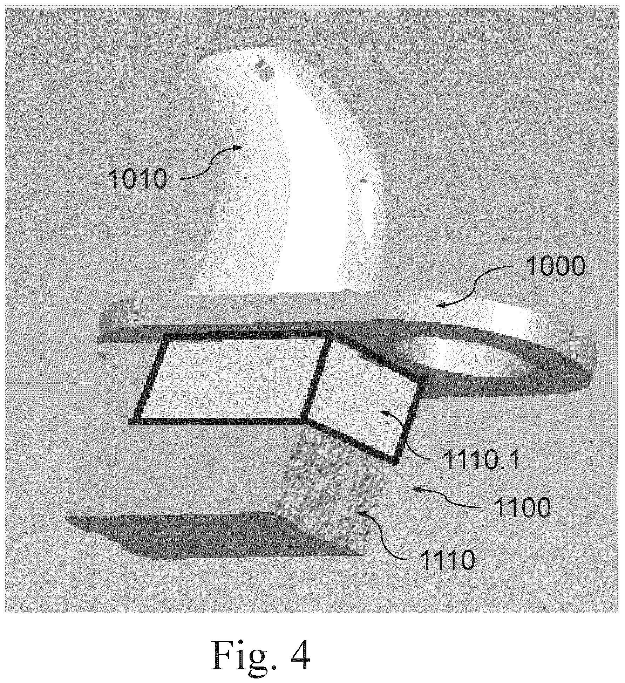

Figure 4 shows a schematic illustration of a connecting device configured as a covering or shielding device that is detachably applied at an insert unit of a hearing aid charging device, where the insert unit takes up a hearing instrument comprising a hearing aid to be charged.

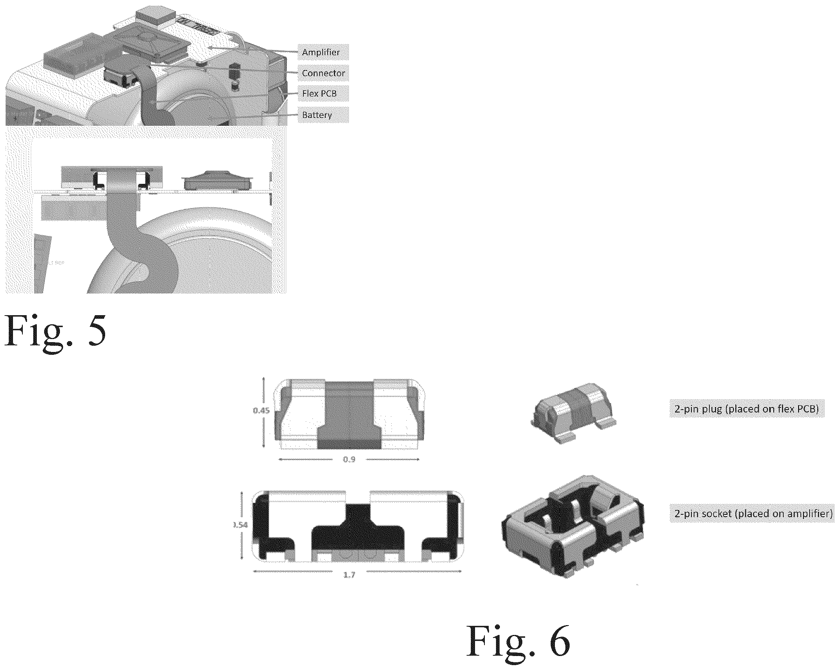

Fig. 5 shows a schematic illustration of a connecting device having a plug/socket connection to an amplifier/substrate of a hearing aid. The connecting device is soldered to the rechargeable battery.

### DETAILED DESCRIPTION OF THE DISCLOSURE

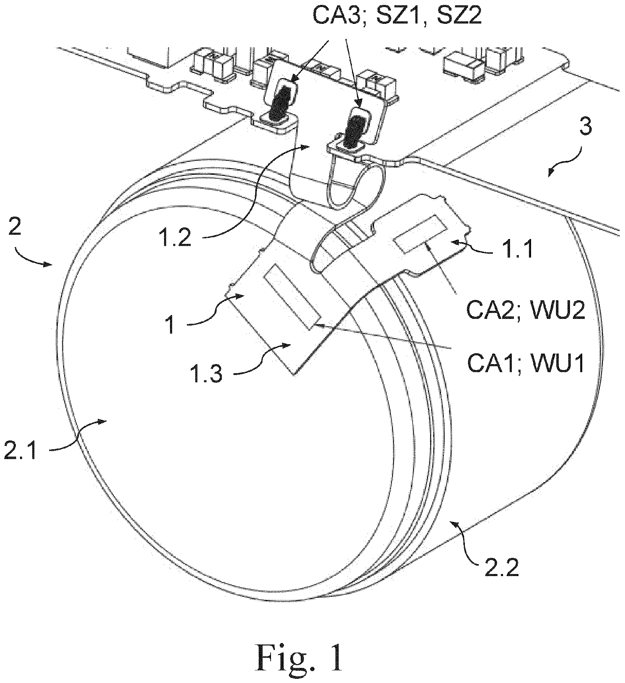

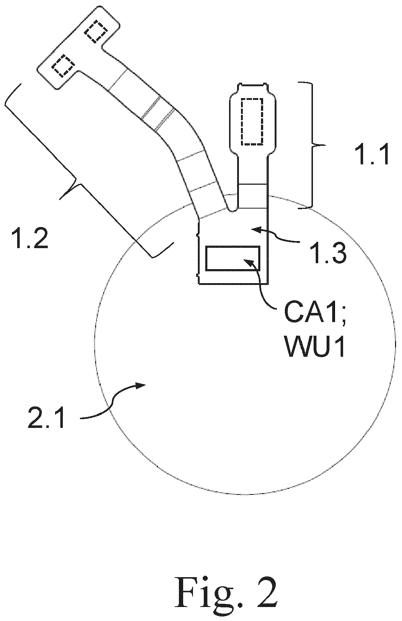

In the following, with reference to Figures 1 and 2, a connecting device **1** according to the disclosure is shown and described. This connecting device **1** is used in a hearing aid (not further shown here).

The connecting device **1** cooperates with a battery unit **2** of a hearing aid and with an electronic component **3** of the hearing aid, which is here the amplifier **3** of the hearing aid. The amplifier 3 comprises one or more electronic components mounted on a substrate, which may be or comprise a rigid substrate. Of course, in other configurations, the electronic component can be any other appropriate electronic component in the hearing aid where the connecting device can connect to in a detachable manner. The battery unit **2** comprises a rechargeable battery **2.1** that rests within a housing unit **2.2** of the battery unit **2.**

Further, the connecting device **1** defines a connecting state, where the connecting device **1** connects to the battery unit **2** in position with respect to the amplifier **3.** As the connecting device 1 is flexible, the connecting device 1 may be attached to e.g. the battery unit 2 prior to assembly of the hearing aid, and, subsequently attached to a substrate before the assembly is arranged in a shell/housing of the hearing aid.

More precisely, the connecting device **1** provides a detachable connection to the rechargeable battery **2.1** via a first welding unit **WU1** and a detachable connection to the housing unit **2.2** of the battery unit **2** via a second welding unit **WU2.** Further, the connecting device **1** provides a detachable connection to the amplifier **3** via a first soldering unit **SU1.** In the present example, the first soldering unit **SU1** composes of two soldering zones **SZ1, SZ2** adjacent to each other. Of course, another number of welding units and soldering units each consisting of several zones may be desirable depending on the specific connecting requirements of the connecting device.

Here, all of these provided detachable connections provide an at least temporarily physical and electrical connection which can easily be realized by proper laser welding and soldering process, providing a reliable connection and a manageable magnetic field without hard-coupling risk from the mass of the rechargeable battery **2.1** and battery unit **2,** respectively, to the amplifier **3.** More precisely, the first welding unit **WU1** is formed by electrode-negative welding, the second welding unit **WU2** is formed by electrode-positive welding, and the two soldering zones **SZ1, SZ2** are formed by soldering process.

As regards the shaping of the connecting device, in an area of minor extension of the connecting device, which can be taken from Figure 1, the connecting device 1 is essentially foil shaped.

In Figure 2, the connecting device **1,** in an area of main extension, is basically V-shaped, thereby comprising a first arm-like element **1.1** and a second arm-like element **1.2,** wherein these two arm-like elements are connected to each other via a transition element **1.3.**

As regards the specific connecting configurations of the connecting device to the connecting partners, the transition element **1.3** comprises a first section of the connecting device with a first connecting area **CA1** for the first welding unit **WU1,** where the first welding unit **WU1** then acts between the first connecting area **CA1** and the rechargeable battery **2.1** resting within the housing unit **2.2** of the battery unit **2.**

Further, the first arm-like element **1.1** comprises a second section of the connecting device **1** with a second connecting area **CA2** for a second welding unit **WU2,** where the second welding unit **WU2** acts between the second connecting area **CA2** and the housing unit **2.2.** The second arm-like element **1.2** comprises a third section of the connecting device **1** with a third connecting area **CA3** for first soldering unit **SU1,** with the first soldering unit **SU1** in the form of the first and second soldering zones **SZ1, SZ2** which act between the third connecting area **CA3** and the amplifier **3** (hence, the third connecting area CA3 comprises the connection area at the connecting device of the two adjacently located soldering zones SZ 1 and SZ2).

As regards the general composition of the connecting device **1** itself, the connecting device **1** essentially consists of a flexible circuit board.

This configuration is very beneficial in providing the flexibility and reliability of the connecting device **1** in terms of reliable attachment function. Furthermore it also provides sufficient compliance in the connecting state to prevent the hard-coupling, since in the connecting state at least a section of the second arm-like element **1.2,** which is essentially made of flexible circuitboard (substrate), acts in a manner of a spring element allowing a controlled displacement of the second-arm like element **1.2** in the connecting state between predetermined displacement limits.

In the following, with reference to Figures 3a), 3b) a further connecting device **100** is shown and described. Here the connecting device is configured as a shielding device.

As stated above, the connecting device may also take over further functions besides providing a reliable detachable physical connection (thereby providing an at least temporarily attachment function) and an electrical connection between cooperating components. The connecting device **100** is configured and formed as a covering device **100** and takes over a shielding function.

More precisely, the covering device **100** is associated to a system comprising a hearing aid and a hearing aid charging device (not further shown), wherein the hearing aid charging device wirelessly charges a hearing aid battery **110** when the hearing aid is arranged in a charging position with respect to the hearing aid charging device. Thereby, the covering device **100** defines a covering state, where the covering device **100** essentially rests in its position with respect to the hearing aid charging device and partly overlaps the hearing aid battery **110,** see Figure 3b). Thereby, the covering device **100** also acts as shielding device providing a shielding function to shield the hearing aid battery **110** from wireless charge signals from the hearing aid charging device, that are associated to a generated magnetic field in the wireless charging mode of the hearing aid charging. More precisely, the covering device **100** covers a major fraction (i.e. at least half) of the (otherwise, usually) free surface of the chargeable battery **110** exposed to the magnetic field in the charging mode. With reference to Figure 3b), the covering device **100** covers about 60% of the (otherwise, usually) free surface of the chargeable battery **110,** thereby causing a significant decrease of surface temperature compared to a charging situation where the entire free surface is exposed to the magnetic field, see Figure 3a);
compare Figure 3b): average surface temperature of 28° C where the covering device covers about 60% of the (otherwise, usually) free surface of the battery **110** with Figure 3a): average surface temperature of 32°C where no covering device **100** is present during wireless charging mode of the battery **110.**

Hence, as described above, this covering device **100** also acts as shielding device providing a shielding function to shield the hearing aid battery **110** from wireless charge signals from the hearing aid charging device, that are associated to a generated magnetic field in a wireless charging mode of the hearing aid charging device.

As regards the material composition of the connecting device **100** acting as shielding device, it is formed by a printed circuit board, which is filled with copper and forms a copper layer with a thickness of around 50 um. In other variants, the thickness may have any other value between Sum to 100um.

In the following, with reference to Figure 4, a further connecting device **1000** configured as a covering device and acting as shielding device is shown and described.

The basic concept and function of the connecting device **1000** is the same as described for the connecting device **1000** configured as covering device and acting as shielding device as described above, such that reference is made to the above statements as regards the general concept.

However, now here, the connecting device **1000** configured as covering device and acting as shielding device is detachable, yet integral, part of a charging instrument **1100** for a hearing aid **1010,** as can be seen in Figure 4. The charging instrument **1100** comprises a hearing aid charging device **1110,** a hearing aid battery to be charged (not visible in Figure 4) and the connecting device **1000** configured as covering device and acting as shielding device. Thereby, at least in the covering state of the covering device **1000** and in a charging mode, essentially the entire covering device **1000** is formed as and acting as shielding device to provide the shielding protection for the hearing aid battery. The covering device **1000,** at least in the covering state, is detachable applied at an insert unit **1110.1** of the hearing aid charging device **1110,** where the hearing aid **1010** sits in while charging its hearing aid battery.

Fig. 5 schematically illustrates a connector to connect a rechargeable battery quickly and easily to the rest of the hearing aid. This connector is optimized to be compact, so it can be used in a hearing aid. This connector simplifies initial assembly of the battery into the hearing aid, but also allows to replace the battery easily, without compromising quality of the connection.

As discussed above in relation to Fig. 2, the connecting device 1 is preferably soldered to both the battery and to the substrate/amplifier 3. Here in Fig. 5 is presented an alternative solution where a connector plug is mounted at one arm of the connector and the other arm is soldered/welded to the battery. This provides a connector/connecting device which may be fastened to the battery in one process step and when mounting the battery in the housing along with the substrate carrying the amplifier and other electronic components, the other end of the connecting device may be easily connected to the plug mounted on the substrate. A socket is mounted on the connecting device so that it may easily be connected to establish the electrical connection between the battery and the amplifier.

The rechargeable battery inside a hearing aid needs a stable electrical connection to the amplifier, while the battery (might) need to be replaceable multiple times during the hearing aids' lifetime. Today this is solved by manually soldering the battery to the amplifier. The available solutions require large footprints on the amplifier or large volumes relative to the size of hearing aids.

In Fig. 6 the presented solution uses a flexible substrate, such as in the form of a flexible PCB or similar, that is welded, at one end, onto the battery directly and is configured with a 2-pin plug soldered on the other end, alternatively a 2-pin socket may be used. The 2-pin plug mates with a 2-pin socket on the amplifier (such as the substrate carrying the amplifier). As shown in Fig. 6, the plug and socket may be provided with a size in the range of less than 1.8 mm in length and less than 0.6 mm in height. As shown in Fig. 6, the size of the socket may be in the range of 1.7 mm x 0.54 mm and the size of the plug may be in the range of 00.9 mm x 0.45 mm. The plug may be provided as a plastic block with contacts arranged thereon. The socket may be provided with guide sides e.g. in plastic to guide the plug into contact with electrical connections mating the metal contacts. Compared to the other embodiments presented herein, the socket and plug connection could be used as an alternative to one or more of the solder units on or at the substrate 3.

Such a combination of plug/socket on a flexible substrate connecting a battery with an amplifier part is contemplated to provide a fast assembly in the production line compared to a solution where the battery is soldered manually at both ends. This connector will make the assembly easier and less time consuming. Further, the present solution provides increased control over battery connection: Manual soldering are varying in quality, depending on for example the operator or the amount of soldering material used, whereas the present solution allow for at least partly automated assembly. Battery using the present solution is exchangeable easily and multiple times: The battery of a hearing aid needs to be replaceable multiple times during the instrument's lifetime. Today, the battery is desoldered and a new battery is soldered into place. This requires sealing the new soldering against corrosion with a manual application of a protective coating. Further the soldering quality might be reduced after several soldering processes. The present solution may provide protection against corrosion as the connector may be designed in a way to seal the contacts against ingress, which will improve robustness against corrosion. Further, the present solution may provide the possibility to utilize modularity and less development time: This design may be implemented easily into different products, thereby reducing development time and ensuring consistent quality. The present solution further offers an advantage when it comes to size, namely that the presented connector may be optimised for a compact footprint and height in order to be able to be used inside a hearing aid. The present solution further provides less production time and cost: Today battery soldering and desoldering is long and a costly step during product assembly operations. Omitting this step will reduce the cost and increase the production speed significantly.

The particular features, structures or characteristics may be combined as suitable in one or more embodiments of the disclosure. The previous description is provided to enable any person skilled in the art to practice the various aspects described herein. Various modifications to these aspects, variants and configurations will be readily apparent to those skilled in the art, and the generic principles defined herein may be applied to other aspects.

Accordingly, the scope should be judged in terms of the claims that follow.

The present disclosure generally relates to the following items
1. Connecting device,
   - said connecting device (1) being configured to cooperate with a battery unit (2) of a hearing aid and with an electronic component (3) of said hearing aid,
   - said connecting device (1) defining a connecting state, where said connecting device (1) essentially establish an electrical connection between said battery unit (2) and said electronic component (3),
   characterized in that
   - said connecting device (1) is configured to provide a detachable connection to said battery unit (2) via at least one welding unit (WU1, WU2) and to provide a detachable connection to said electronic component (3) of said hearing aid via at least one soldering unit (SU1).
2. Connecting device according to item 1, wherein
   - said connecting device (1) is configured to provide said detachable connection to a rechargeable battery (2.1) and a battery housing (2.2) of said battery unit (2) via at least a first and a second welding unit (WU1, WU2) and to provide a detachable connection to said electronic component (3) in the form of an amplifier (3) via said at least first soldering unit (SU1).
3. Connecting device according to item 1 or 2, wherein
   - said detachable connection to said battery unit (2) via said at least one welding unit (WU1, WU2) is provided as physical and electrical detachable connection, and
   - said detachable connection to said electronic component (3) of said hearing aid via said at least one soldering unit (SU1) is provided as physical and electrical detachable connection.
4. Connecting device according to any of the preceding items, wherein
   - said at least one welding unit (WU1, WU2) comprises at least a first welding unit (WU1) and a second welding unit (WU2),
   - said at least one soldering unit (SU1) comprises at least a first soldering unit (SU1),
   wherein
   - said first welding unit (WU1) is formed by laser welding process,
   - aid second welding unit (WU2) is formed by laser welding process,
   - said first soldering unit (SU1) is formed by soldering process.
5. Connecting device according to any of the preceding items, wherein
   - said at least one welding unit (WU1, WU2) comprises at least a first welding unit (WU1) and a second welding unit (WU2),
   - said at least one soldering unit (SU1) comprises at least a first soldering unit (SU1),
   wherein
   - aid first welding unit (WU1) is formed by electrode-negative welding,
   - said second welding unit (WU2) is formed by electrode-positive welding,
   - said first soldering unit (SU1) is formed by soldering.
6. Connecting device according to any of the preceding items, wherein
   - said connecting device (1) is configured to provide, in said connecting state, said detachable connection to said battery unit (2) via at least a first welding unit (WU1) and a second welding unit (WU2),
   - said first welding unit (WU1) acting between a first connecting area (CA1) of a first section of said connecting device (1) and an essentially free surface of a rechargeable battery (2.1) of said battery unit (2), said rechargeable battery (2.1) resting within a housing unit (2.2) of said battery unit (2),
   - said second welding unit (WU2) acting between a second connecting area (CA2) of a second section of said connecting device (1) and said housing unit (2.2), said housing unit (2.2) housing said rechargeable battery (2.1) of said battery unit (2) and at least temporarily hold said rechargeable battery (2.1) in position.
7. Connecting device according to any one of items 4 to 6, wherein
   - said first welding unit (WU1) comprises at least two first welding unit zones, said at least two first welding unit zones in particular being located adjacent to each other,
      and/or
   - said second welding unit (WU2) comprises at least two second welding unit zones, said at least two second welding unit zones in particular being located adjacent to each other.
8. Connecting device according to any of the preceding items, wherein
   - said connecting device is (1) configured to provide, in said connecting state, said detachable connection to said electronic component (3) via at least a first soldering unit (SU1),
   wherein
   - said first soldering unit (SU1) acting between a third connecting area (CA3) of a third section of said connecting device (1) and said electronic component (3) of said hearing aid, said electronic component (3) in particular being an amplifier (3) of said hearing aid,
      and/or
   - said first soldering unit (SU1) comprises at least two first soldering unit zones (SZ1, SZ2), said at least two first soldering unit zones (SZ1, SZ2) in particular being located adjacent to each other.
9. Connecting device according to any of the preceding items, wherein
   - at least when considered in a non-connecting state when said connecting device (1) is essentially unloaded, said connecting device (1), in its axis of minor extension, being essentially foil shaped, and in a, in particular essentially curved, area of main extension being essentially U-shaped or V-shaped.
10. Connecting device according to any one of the preceding items, wherein
   - said connecting device (1) comprises at least a first (1.1) and second (1.2) arm-like element and a transition element (1.3), wherein said first (1.1) and second (1.2) arm-like elements are connected to each other via said transition element (1.3).
11. Connecting device according to item 10, wherein
   - said transition element (1.3) comprising a first section of said connecting device (1) with a first connecting area (CA1) for a first welding unit (WU1), said first welding unit (WU1) being configured to act between said first connecting area (CA1) and a rechargeable battery (2.1) of said battery unit (2), said rechargeable battery (2.1) resting within a housing unit (2.2) of said battery unit (2),
   - said first arm-like element (1) comprising a second section of said connecting device (1) with a second connecting area (CA2) for a second welding unit (WU2), said second welding unit (WU2) being configured to act between said second connecting area (CA2) and said housing unit (2.2), said housing unit (2.2) housing said rechargeable battery (2.1) of said battery unit (2) and at least temporarily hold said rechargeable battery (2.1) in position,
   - said second arm-like element (1.2) comprising a third section of said connecting device (1) with a third connecting area (CA3) for first soldering unit (SU1), said first soldering unit (SU1) being configured to act between said third connecting area (CA3) and said electronic component (3) of said hearing aid, said electronic component (3) in particular being an amplifier (3) of said hearing aid.
12. Connecting device according to any of the preceding items, wherein
   - said connecting device (1) comprises at least a first (1.1) and second (1.2) arm-like element and a transition element (1.3), wherein said first (1.1) and second (1.2) arm-like elements are connected to each other via said transition element (1.3),
   wherein
   - said second arm-like element (1.2) provides a stiffness characteristic, which in particular varies section-wise, and provides a geometric curvature in a non-connecting state when said connecting device (1) is essentially unloaded such that in said connecting state, said second-arm like element (1.2) at least temporarily cooperates with and is detachably fixable to said electronic component (3) of said hearing aid, wherein
   - at least a section of said second arm-like element (1.2) in said connecting state acts in a manner of a spring element allowing a controlled displacement of said second-arm like element (1.2) in said connecting state between predetermined displacement limits.
13. Connecting device according to any of the preceding items, wherein
   - at least a section of said connecting device (1) is formed by at least one printed circuit board,
      and/or
   - said connecting device (1) is essentially made of at least one printed circuit board, wherein in particular,
   - at least when considered in a non-connecting state when said connecting device (1) is essentially unloaded, said connecting device (1), in its axis of minor extension, is essentially foil shaped, and in a, in particular essentially curved, area of main extension is essentially U-shaped or V-shaped,
      and/or
   - said connecting device (1) comprises at least a first (1.1) and second (1.2) arm-like element and a transition element (1.3), wherein said first (1.1) and second (1.2) arm-like elements are connected to each other via said transition element (1.3).
14. Connecting device according to any of the preceding items, wherein
   - said connecting device (1), when providing said detachable connection to said battery unit (2) via said at least one welding unit (WU1, WU2), said connecting device (1) is further configured to cover at least a fraction, preferably a major fraction, more preferably at least half, of a free surface of a rechargeable battery (2.1), which is housed within a housing unit (2.2) of said battery unit (2), such that said connecting device (1) further provides a cover function and/or a shielding function for said rechargeable battery (2.1) of said battery unit (2), in particular against overheating of said rechargeable battery (2.1) when said connecting device (1) and said detachable connected rechargeable battery (2.1) is exposed to a generated magnetic field.
15. Hearing aid
   - with a battery unit (2) and a connecting device (1) according to any of the items 1 to 14 cooperating with said battery unit (2) and an electronic component (3), preferably an amplifier (3), of said hearing aid,
   - said battery unit (2) comprising a rechargeable battery (2.1) at least temporarily housed within a housing unit (2.2) of said batter unit (2).

## Claims

1. Hearing aid comprising:
- a battery unit (2) and a connecting device (1) cooperating with said battery unit (2), said connecting device (1) further cooperating with an electronic component (3) positioned on a substrate of said hearing aid,
- said battery unit (2) comprising a rechargeable battery (2.1)
- said connecting device (1) defining a connecting state, where said connecting device (1) essentially establish an electrical connection between said battery unit (2) and said electronic component (3) via at least one soldering unit (SU1) or via a plug-and-socket connector,
- said connecting device (1) is configured to provide a connection to said battery unit (2) via at least one welding unit (WU1, WU2).

2. Hearing aid according to claim 1, wherein
said connecting device (1) is or comprise a flexible substrate.

3. Hearing aid according to claim 1 or 2, wherein
- said connecting device (1) is configured to provide said connection to a rechargeable battery (2.1) and a battery housing (2.2) of said battery unit (2) via at least a first and a second welding unit (WU1, WU2) and to provide a connection to said electronic component (3) in the form of an amplifier (3) via said at least first soldering unit (SU1) or via said plug-and-socket connector.

4. Hearing aid according to any one of claims 1-3, wherein
- said connection to said battery unit (2) via said at least one welding unit (WU1, WU2) is provided as physical and electrical connection, and
- said connection to said electronic component (3) of said hearing aid via said at least one soldering unit (SU1) is provided as physical and electrical connection.

5. Hearing aid according to any of the preceding claims, wherein
- said a plug-and-socket connector comprises a socket positioned on a substrate connected to said electronic component and said plug is positioned on said connecting device, said plug-and-socket connector establishing a releasable connection.

6. Hearing aid according to any of the preceding claims, wherein
- said at least one welding unit (WU1, WU2) comprises at least a first welding unit (WU1) and a second welding unit (WU2),
- said at least one soldering unit (SU1) comprises at least a first soldering unit (SU1),
wherein
- aid first welding unit (WU1) is formed by electrode-negative welding,
- said second welding unit (WU2) is formed by electrode-positive welding,
- said first soldering unit (SU1) is formed by soldering.

7. Hearing aid according to any of the preceding claims, wherein
- said connecting device (1) is configured to provide, in said connecting state, said connection to said battery unit (2) via at least a first welding unit (WU1) and a second welding unit (WU2),
- said first welding unit (WU1) acting between a first connecting area (CA1) of a first section of said connecting device (1) and an essentially free surface of a rechargeable battery (2.1) of said battery unit (2), said rechargeable battery (2.1) resting within a housing unit (2.2) of said battery unit (2),
- said second welding unit (WU2) acting between a second connecting area (CA2) of a second section of said connecting device (1) and said housing unit (2.2), said housing unit (2.2) housing said rechargeable battery (2.1) of said battery unit (2) and at least temporarily hold said rechargeable battery (2.1) in position.

8. Hearing aid according to any one of claims 6 to 7, wherein
- said first welding unit (WU1) comprises at least two first welding unit zones, said at least two first welding unit zones in particular being located adjacent to each other,
and/or
- said second welding unit (WU2) comprises at least two second welding unit zones, said at least two second welding unit zones in particular being located adjacent to each other.

9. Hearing aid according to any of the preceding claims, wherein
- said connecting device is (1) configured to provide, in said connecting state, said connection to said electronic component (3) via at least a first soldering unit (SU1),
wherein
- said first soldering unit (SU1) acting between a third connecting area (CA3) of a third section of said connecting device (1) and said electronic component (3) of said hearing aid, said electronic component (3) in particular being an amplifier (3) of said hearing aid,
and/or
- said first soldering unit (SU1) comprises at least two first soldering unit zones (SZ1, SZ2), said at least two first soldering unit zones (SZ1, SZ2) in particular being located adjacent to each other.

10. Hearing aid according to any of the preceding claims, wherein
- at least when considered in a non-connecting state when said connecting device (1) is essentially unloaded, said connecting device (1), in its axis of minor extension, being essentially foil shaped, and in a, in particular essentially curved, area of main extension being essentially U-shaped or V-shaped.

11. Hearing aid to any one of the preceding claims, wherein
- said connecting device (1) comprises at least a first (1.1) and second (1.2) arm-like element and a transition element (1.3), wherein said first (1.1) and second (1.2) arm-like elements are connected to each other via said transition element (1.3).

12. Hearing aid according to claim 11, wherein
- said transition element (1.3) comprising a first section of said connecting device (1) with a first connecting area (CA1) for a first welding unit (WU1), said first welding unit (WU1) being configured to act between said first connecting area (CA1) and a rechargeable battery (2.1) of said battery unit (2), said rechargeable battery (2.1) resting within a housing unit (2.2) of said battery unit (2),
- said first arm-like element (1) comprising a second section of said connecting device (1) with a second connecting area (CA2) for a second welding unit (WU2), said second welding unit (WU2) being configured to act between said second connecting area (CA2) and said housing unit (2.2), said housing unit (2.2) housing said rechargeable battery (2.1) of said battery unit (2) and at least temporarily hold said rechargeable battery (2.1) in position,
- said second arm-like element (1.2) comprising a third section of said connecting device (1) with a third connecting area (CA3) for first soldering unit (SU1), said first soldering unit (SU1) being configured to act between said third connecting area (CA3) and said electronic component (3) of said hearing aid, said electronic component (3) in particular being an amplifier (3) of said hearing aid.

13. Hearing aid according to any of the preceding claims, wherein
- said connecting device (1) comprises at least a first (1.1) and second (1.2) arm-like element and a transition element (1.3), wherein said first (1.1) and second (1.2) arm-like elements are connected to each other via said transition element (1.3),
wherein
- said second arm-like element (1.2) provides a stiffness characteristic, which in particular varies section-wise, and provides a geometric curvature in a non-connecting state when said connecting device (1) is essentially unloaded such that in said connecting state, said second-arm like element (1.2) at least temporarily cooperates with and is detachably fixable to said electronic component (3) of said hearing aid, wherein
- at least a section of said second arm-like element (1.2) in said connecting state acts in a manner of a spring element allowing a controlled displacement of said second-arm like element (1.2) in said connecting state between predetermined displacement limits.

14. Hearing aid according to any of the preceding claims, wherein
- at least a section of said connecting device (1) is formed by at least one printed circuit board,
and/or
- said connecting device (1) is essentially made of at least one printed circuit board, wherein in particular,
- at least when considered in a non-connecting state when said connecting device (1) is essentially unloaded, said connecting device (1), in its axis of minor extension, is essentially foil shaped, and in a, in particular essentially curved, area of main extension is essentially U-shaped or V-shaped,
and/or
- said connecting device (1) comprises at least a first (1.1) and second (1.2) arm-like element and a transition element (1.3), wherein said first (1.1) and second (1.2) arm-like elements are connected to each other via said transition element (1.3).

15. Hearing aid according to any of the preceding claims, wherein
- said connecting device (1), when providing said connection to said battery unit (2) via said at least one welding unit (WU1, WU2), said connecting device (1) is further configured to cover at least a fraction, preferably a major fraction, more preferably at least half, of a free surface of a rechargeable battery (2.1), which is housed within a housing unit (2.2) of said battery unit (2), such that said connecting device (1) further provides a cover function and/or a shielding function for said rechargeable battery (2.1) of said battery unit (2), in particular against overheating of said rechargeable battery (2.1) when said connecting device (1) and said connected rechargeable battery (2.1) is exposed to a generated magnetic field.
